# EUROPEAN PATENT APPLICATION

(11) **EP 1 104 058 A2**
(43) Date of publication of application: **30.05.2001**
(21) Application number: 00125881.3
(22) Date of filing: 25.11.2000
(51) Int. Cl.: H01S 5/223, H01S 5/323, H01L 33/00

(54) **Semiconductor optical device having a compound semiconductor layer including aluminium**

(30) Priority: 26.11.1999 JP 33540399
(71) Applicant: THE FURUKAWA ELECTRIC CO., LTD., Tokyo (JP)
(72) Inventor: Arakawa, Satoshi, c/0 The Furukawa Electric Co Ltd, Tokyo (JP); Ishikawa, Takuya, c/0 The Furukawa Electric Co Ltd, Tokyo (JP); Ito, Mitsumasa, c/0 The Furukawa Electric Co Ltd, Tokyo (JP); Kasukawa, Akihiko, c/0 The Furukawa Electric Co, Tokyo (JP)
(74) Representative: Pätzold, Herbert, Dr.-Ing.

(57) **Abstract**

A selective growth process for depositing a compound semiconductor layer (32) or a semiconductor optical device including A1 includes the step of introducing a mixture of source gas for the compound semiconductor layer (32) and halogen compound gas including carbon and halogen. The halogen compound gas suppresses deposition of polycrystalline substance and allows a higher growth rate at a lower temperature. The process is applied to burying process, selective area growth process and butt joint growth process.

## Description

### BACKGROUND OF THE INVENTION

### (a) Field of the Invention

The present invention relates to a semiconductor optical device having a compound semiconductor layer including aluminum (Al) and, more particularly, to a semiconductor optical device having a compound semiconductor layer having excellent characteristics. The present invention also relates to a method for selective growth of a compound semiconductor layer including therein Al in a semiconductor optical device.

### (b) Description of the Related Art

A semiconductor laser device known as an buried-ridge semiconductor laser device includes ridge-shaped current injection layers buried by current blocking layers at both sides of the ridge. This type of semiconductor laser device is widely used as a pick-up in the field of optical disk. An AlGaInP/GaAs semiconductor laser device is a typical one among such buried-ridge semiconductor laser devices, includes a GaAs current blocking layer and emits light having a wavelength of 650 nm.

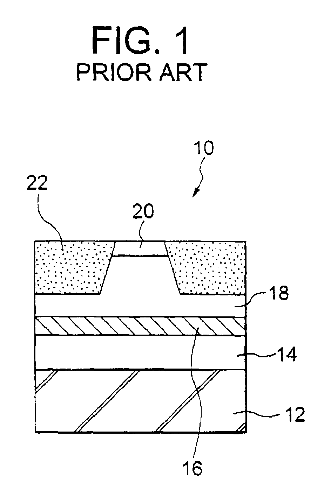

Fig. 1 shows a conventional buried-ridge AlGaInP/GaAs semiconductor laser device 10, which includes an n-type GaAs (n-GaAs) substrate 12, and a layered structure formed thereon and including a 1500-nm-thick n-AlGaInP ((Al_{z}Ga_{1-z})ₓIn₁₋ₓP, x=0.5 and z=0.7) lower cladding layer 14, GaInP/AlGaInP multiple quantum well (MQW) layers 16, a 1500-nm-thick p-AlGaInP ((Al_{z}Ga_{1-z})ₓIn₁₋ₓP, x=0.5 and z=0.7) upper cladding layer 18, and a 300-nm-thick p-GaAs contact layer 20.

The top portion of the upper cladding layer 18 and the contact layer 20 is configured as a ridge stripe, both sides of which is buried by a GaAs layer 22 acting as a current blocking layer. A p-side electrode formed on the contact layer 20 and an n-side electrode formed on the bottom surface of the GaAs substrate 12 are not depicted in the drawing.

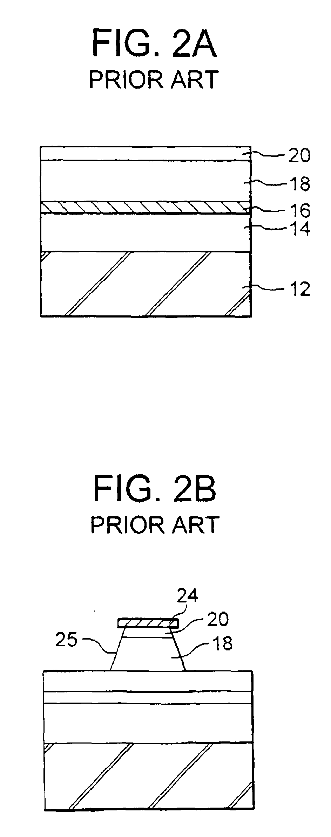

A process for fabrication of the semiconductor laser device 10 of Fig. 1 is described with reference to Figs. 2A and 2B, which consecutively show fabrication steps of the semiconductor laser device 10.

First, as shown in Fig. 2A, a 1500-nm-thick n-AlGaInP lower cladding layer 14, GaInP/AlGaInP MQW layers 16, a 1500-nm-thick p-AlGaInP upper cladding layer 18 and an n-GaAs contact layer 20 are consecutively grown on an n-GaAs substrate 12 by a first epitaxial step using a MOCVD technique to form a layered structure.

Subsequently, as shown in Fig. 2B, a SiN film is formed on the contact layer 20, followed by patterning thereof to configure a 5- µm-wide SiN stripe mask 24. The contact layer 20 and the top portion of the upper cladding layer 18 are wet-etched by using a sulfuric acid- or hydrochloric acid-based etchant to form a ridge stripe 25.

Thereafter, a second epitaxial step is conducted to grow a Si-doped n-GaAs current blocking layer 22 on both sides of the ridge stripe 25 by a selective growth technique using the SiN stripe mask 24 as a selective growth mask. Further, a p-side electrode and an n-side electrode are formed on the contact layer 20 and the bottom surface of the GaAs substrate 12, respectively. After cleavage of the wafer, a plurality of semiconductor laser devices 10 such as shown in Fig. 1 are obtained.

In the conventional semiconductor laser device shown in Fig. 1, since the GaAs current blocking layer 22 has a bandgap energy lower than the bandgap energy of the GaInP/AlGaInP MQW layers 16, there is a problem in that the GaAs current blocking layer 22 absorbs the light emitted by the MQW layers 16 and lowers the emission efficiency of the semiconductor laser device.

It has been proposed for solving the above problem to replace the material (GaAs) for the current blocking layer 22 by another material, such as Al(Ga)InP, which is optically transparent to the lasing wavelength.

On the other hand, if a source gas including TMA1 or TMIn is used in the above selective growth step, wherein Al(Ga)InP is deposited to form the current blocking layer by using the SiN selective growth mask, an undesirable polycrystalline substance is deposited on the SiN mask because the Al atom in the source gas is formed as a nucleus of the polycrystalline substance and the nucleus reacts with the other components in the source gas to form the crystalline substance around the nucleus.

The polycrystalline substance deposited on the SiN mask has a strong bond with the SiN mask and is hardly etched by hydrofluoric acid. Thus, although a wet etching for the SiN mask is conducted using hydrofluoric acid after the selective growth process, the polycrystalline substance remains and the SiN remains after the wet etching. This causes an uneven surface and impedes the subsequent epitaxial steps. In addition, the remaining polycrystalline substance and SiN mask adversely affect the optical characteristics of the optical device as foreign materials changing the composition of the compound semiconductor layers. This problem is common to selective growth processes using selective growth masks other than the SiN mask in the semiconductor optical devices.

The deposition of the polycrystalline substance itself may be prevented by a higher temperature or a lower growth rate in the epitaxial growth of Al(Ga)InP, as employed in the conventional technique.

However, a higher temperature degrades the laser characteristics because Zn injected as doping impurities in the p-AlGaInP upper cladding layer are diffused into the MQW layers. On the other hand, a lower growth rate degrades the throughput of the fabrication.

In the conventional fabrication technique for the semiconductor laser devices, a variety of problems are also encountered in the selective growth of compound semiconductor materials including A1 contents, such as AlGaAs and AlGaInAs, other than the selective growth of the current blocking layer as described above. This is caused by the fact that the Al content therein forms a nucleus and is then reacted with other components in the source gas during the selective growth step.

The selective growth technique as described heretofore is also used for a selective area growth process. The selective area growth process is such that a compound semiconductor is grown to form a film on a specified growth area exposed by a pair of growth prevention masks, for example, which are formed on the area other than the specified growth area for prevention of deposition of the compound semiconductor thereon. In this technique, there is an advantage in that the thickness and the contents of the resulting film can be controlled.

### SUMMARY OF THE INVENTION

In view of the above, it is an object of the present invention to provide a semiconductor optical device having a compound semiconductor layer deposited by a selective growth process and having excellent layer characteristics.

It is another object of the present invention to provide a method for fabricating a semiconductor optical device, which is capable of preventing deposition of a polycrystalline substance during a selective growth of a compound semiconductor including Al.

The present invention provides a semiconductor optical device including a semiconductor substrate, and a layered structure formed thereon, the layered structure including a first conductivity-type current injection layer formed as a ridge stripe and a second conductivity-type current blocking layer burying the current injection layer at both side of the ridge stripe, wherein the current blocking layer is doped with impurities including at least carbon.

Examples of the semiconductor optical device according to the present invention include a light emitting/receiving semiconductor device, an optical waveguide, an optical amplifier and an integrated semiconductor optical device including two or more of them. The current blocking layer may be an AlGaInP or AlGaAs layer in the case of a semiconductor optical device formed on a GaAs substrate, or an AlGaInAs layer in the case of a semiconductor optical device formed on an InP substrate. The impurities for doping the current blocking layer may include at least one of Si, Se and Zn in addition to carbon, whereby a semiconductor optical device can be achieved which includes a desired current blocking layer having an excellent controllability with respect to the conductivity-type and the carrier density thereof.

In accordance with the semiconductor optical device of he present invention, the current blocking layer doped with impurities including carbon affords a desired device characteristic in the semiconductor optical device.

The present invention provides a method including the steps of forming a compound semiconductor layer overlying a substrate and including Al, and forming a semiconductor optical device including the compound semiconductor layer, wherein the compound semiconductor layer forming step uses a mixture of source gas for the compound semiconductor layer and halogen compound gas including halogen and carbon.

The present invention provides, in one aspect thereof, a first method including the steps of forming a current injection layer overlying a semiconductor substrate and configured as a ridge stripe, epitaxially growing a current blocking layer doped with at least carbon and burying the ridge stripe at both sides of the ridge stripe by using a mixture of source gas for the current blocking layer and additional halogen compound gas including carbon atoms and halogen atoms, and forming a semiconductor optical device including the current injection layer and the current blocking layer.

In accordance with the first method of the present invention, the epitaxial growth of the current blocking layer can be conducted at a lower temperature with a high throughput.

The present invention also provides, in another aspect thereof, a second method including the steps of selectively growing a compound semiconductor layer including Al by using a selective area growth mask while introducing a mixture of a source gas for the compound semiconductor layer and additional halogen compound gas including carbon atoms and halogen atoms, and forming a semiconductor optical device including the compound semiconductor layer.

In accordance with the second method of the present invention, the mixture of source gas and additional halogen compound gas suppresses deposition of polycrystalline substance, and affords excellent controllability of the conductivity-type and the carrier density of the compound semiconductor layer.

The present invention also provides, in another aspect thereof, a third method including the steps of selectively growing a compound semiconductor layer including Al by using a selective growth mask while introducing a mixture of source gas for the compound semiconductor layer and etching gas including bromine, and forming a semiconductor optical device including the compound semiconductor layer.

In accordance with the third method of the present invention, the etching gas including bromine suppresses deposition of polycrystalline substance to achieve a higher selectivity in the selective growth process substantially without involving an adverse effect in the resultant compound semiconductor layer.

The above and other objects, features and advantages of the present invention will be more apparent from the following description, referring to the accompanying drawings.

### BRIEF DESCRIPTION OF THE DRAWINGS

Fig. 1 is a sectional view of a conventional buried-ridge semiconductor laser device.

Figs. 2A and 2B are sectional views of the semiconductor laser device of Fig. 1, showing consecutive steps for fabrication thereof.

Fig. 3 is a top plan view of the semiconductor optical device fabricated in the third experiments.

Figs. 4A and 4B are photographs taken by an optical microscope for the comparative example and embodiment obtained in the third experiments, respectively.

Fig. 5 is a graph showing the relationship between the deposited particles and the flow rate of CBr₄.

Figs. 6A to 6C are schematic perspective views of a semiconductor laser device formed in the fourth experiments, showing consecutive steps for fabrication thereof.

Fig. 7 is a sectional view of a semiconductor laser device according to an embodiment of the present invention.

Fig. 8 is a graph showing relationship between the deposited amount of polycrystalline substance and the flow rate of CBr₄.

Fig. 9 is a graph showing relationship between the carrier density and the flow rate of CBr₄.

Fig. 10 is a graph between the threshold current and the carrier density with the growth temperature being a parameter.

Fig. 11 is a top plan view of selective area growth masks on a semiconductor substrate.

Figs. 12A and 12B are sectional views taken along lines A-A' and B-B' in Fig. 11.

Figs. 13A and 13B are sectional views of deposited films taken along lines A-A' and B-B' in Fig. 11.

Fig. 14 is a graph showing the thickness distribution of selectively grown layer.

Fig. 15 is a graph showing the lasing wavelength emitted from the areas shown in Fig. 11.

Figs. 16A to 16B are perspective views of a semiconductor laser device according to an embodiment, showing consecutive steps of fabrication thereof.

Figs. 17A and 17B are perspective views of a semiconductor laser device, showing selective area growth.

Fig. 18A to 18F are perspective views of a semiconductor laser device, showing butt joint growth.

### PREFERRED EMBODIMENTS OF THE INVENTION

Now, the present invention is more specifically described with reference to accompanying drawings, wherein similar constituent elements are designated by similar reference numerals throughout the drawings.

Before describing embodiments of the present invention, the principle of the present invention is described with reference to the experiments conducted by the present inventors.

The present inventors considered that the above problems could be solved by changing the contents of the source gas in the selective growth of the Al(Ga)InP to form a current blocking layer, and thus conducted a variety of experiments using a variety of source gases to selectively grow Al(Ga)InP current blocking layers, as detailed below.

### First Experiments

In these experiments, halogen compound gases each including carbon and halogen, such as CBr₄ and CCl₄, are used as the source gases.

It was confirmed from the experiments that the halogen atoms in the halogen compound gas had a function for etching the polycrystalline substance deposited during the selective growth, whereby even a lower-temperature selective growth achieved suppression of the deposition of polycrystalline substance.

In addition, it was also confirmed that the carbon atoms in the halogen compound gas enters the Al(Ga)InP compound to be doped in the resultant film, whereby the conductivity of the n-type film can be controlled.

More specifically, the polycrystalline substance, which is formed by reaction of Al with the contents in the source gas, is removed as a growth nucleus in the initial stage of the growth by the etching function of CBr₄ or CCl₄, whereby generation of the polycrystalline substance can be suppressed.

It was also confirmed in the experiments that C-doped Al(Ga)InAs could be grown as the current blocking layer in the case where the ridge is buried by an AlInAs layer in an AlGaInAs/InP-based semiconductor laser device formed on an InP substrate.

It was also confirmed in the experiments that C-doped p-AlGaAs could be grown as the current blocking layer in the case where the ridge is buried by an AlGaAs layer in an AlGaAs/GaAs-based semiconductor laser device formed on a p-GaAs substrate.

### Second Experiments

As to the deposition problem of the polycrystalline substance, it was also confirmed effective to use the epitaxial growth technique using a mixture of source gas and halogen compound gas including carbon and halogen, such as CBr₄ or CCl₄, in the selective area growth process, as well as in the burying growth process for deposition of the current blocking layer as described above.

It is known in the selective area growth of a compound semiconductor layer including Al, that the thickness of the resultant compound semiconductor layer is significantly smaller than the thickness of a typical current blocking layer. Although the deposition of the polycrystalline substance may be suppressed to some extent by employing a lower growth rate or a lower ratio of group-V atoms to group-III atoms, a small amount of the additional halogen compound gas including halogen and carbon suppresses the deposition of polycrystalline substance more assuredly, and thus enables the concentration of carbon to be reduced to a lower rate in the resultant layer thereby allowing a more accurate control of the carrier density therein.

CBr₄ gas, if used for deposition of a barrier layer in MQW layers as the additional halogen compound gas, allows a modulated doping of the barrier layer. In this case, an effective modulating doping can be achieved due to improvement of selective growth characteristics and restricted diffusion of the doped carbon.

As described before, although the conventional technique used a lower growth rate or a higher growth temperature for the suppression of polycrystalline substance, the suppression was only limited. In addition, since these measures deviate from an optimum growth rate, the device characteristics were degraded. For example, the lower growth rate, if used for a compound semiconductor including Al, increases the density of impurities, such as oxygen, and thereby degrades the optical and electric characteristics of the resultant layer.

It was also confirmed in the experiments based on the methods of the present invention that an etching gas, if introduced in the growth chamber, i.e., onto the substrate during the selective growth of the compound semiconductor layer including Al, the deposition of the polycrystalline substance could be further suppressed.

Among the experiments conducted, the following third and fourth experiments will be described for a better understanding of the present invention. In these experiments, an etching gas including bromine was used instead of an etching gas including chlorine because the latter is likely to damage the deposition system and the natural environment.

### Third Experiments

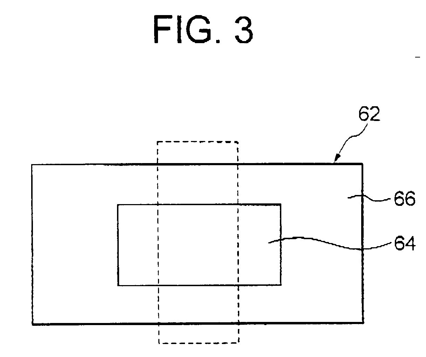

As an example of general selective growth processes, AlInAs layer was grown on an InP substrate covered with a mask pattern based on the principle of the present invention. With reference to Fig. 3, in the present experiments, a 100-nm-thick SiN film 64 was deposited on an InP substrate 62 by a plasma-enhanced CVD technique, followed by photolithography and wet-etching using hydrofluoric acid for patterning to obtain a selective growth mask 64 having a width of 80 µm and a length of 600 µm.

By using a source gas including trimethyl indium (TMIn), trimethyl aluminum (TMAl) or arsine (AsH₃) in each of the experiments, a 500-nm-thick AlInAs layer 66 was formed on the masked substrate, using a MOCVD technique, at a temperature of 680°C, a pressure of 100 hPa and a growth rate of 1.8 µm.

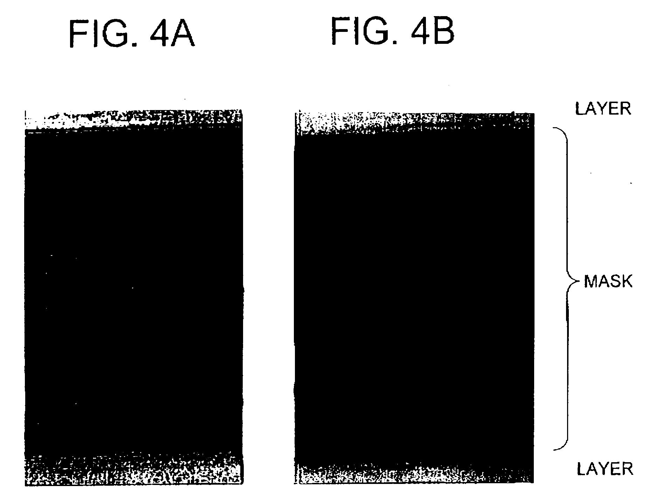

As a comparative example, an AlInAs layer was formed without supplying the etching gas in the growth chamber. In the comparative example, as shown in Fig. 4A, polycrystalline substance (appearing as dark spots) was deposited in a large amount, difficult to remove by later etching, and became an impediment for the process in the subsequent steps. The polycrystalline substance degraded the yield of the final products.

Fig. 4A, as well as Fig. 4B described below, is obtained by using an optical microscope, wherein the dark area is formed by the mask, and the white areas disposed at top and bottom portions of the film were formed by the AlInAs layer.

As an example of the present experiments, carbon tetrabromide (CBr₄) gas was added to the source gas at a flow rate of 3.2 µmol/minute in the growth chamber during the selective growth of the AlInAs layer. The resultant layer is shown in Fig. 4B, wherein the amount of polycrystalline substance deposited on the mask was reduced to substantially zero.

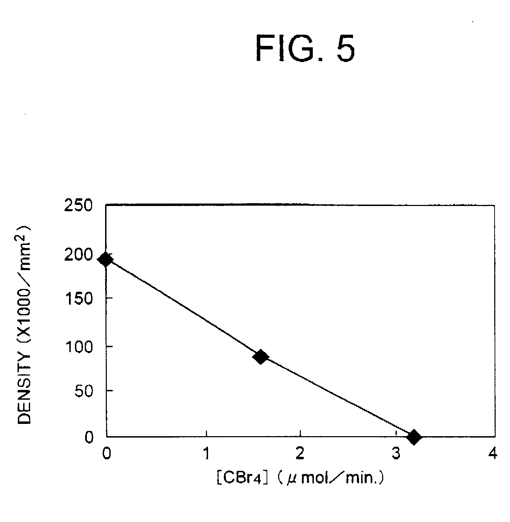

Quantitatively, the amount of polycrystalline substance was reduced together with the increase of the flow rate of CBr₄ gas, as shown in Fig. 5, wherein addition of no CBr₄ gas caused 200×10³ particles/mm² of polycrystalline substance deposited on the mask, addition of CBr₄ gas at a flow rate of 1.6µ mol/minute reduced the number of particles deposited on the mask down to 100×10³ particles/mm², and addition of CBr₄ gas at a flow rate of 3.2 µmol/minute reduced the number of the particles to substantially zero, as shown in Fig. 4B.

Addition of CBr₄ sometime changed the composition and lowered the growth rate of the resultant layer, which was formed on the growth area exposed from the selective growth mask covering the non-growth area. It was confirmed that the change of the composition and reduction of the growth rate could be compensated by controlling the source gas, especially by controlling the flow rates of group-III elements such as in the compounds TMAl and TMIn.

It is preferable to experimentally determine the flow rate of CBr₄, which depends on the composition of the desired AlInAs layer, especially the Al content thereof, the growth rate and temperature thereof, and the size and surface roughness etc. of the mask. The CBr₄ gas can be replaced by other bromine gas such as methyl bromide (CH₃Br).

### Fourth Experiments

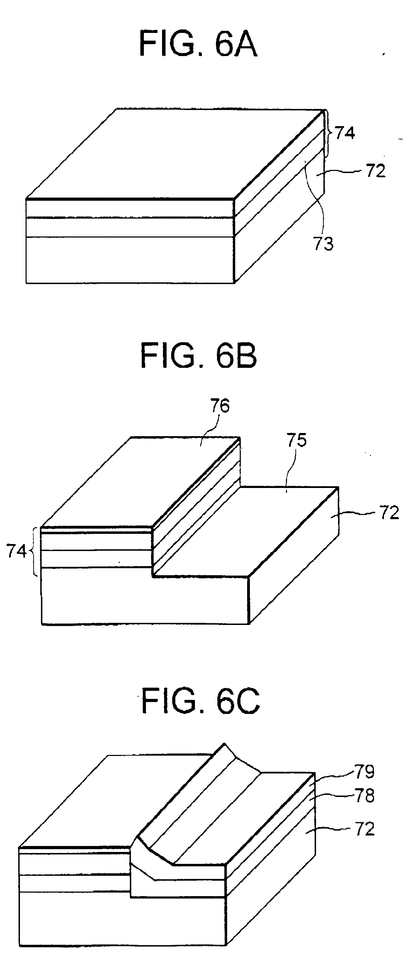

These experiments were conducted for butt joint growth. Figs. 6A to 6C show the process in these experiments. As shown in Fig. 6A, a GaInAsP-based double-heterojunction (DH) structure 74 including a GaInAsP MQW structure 73 was formed on an InP substrate 72. Subsequently, a 100-nm-thick silicon nitride (SiN) film was formed thereon, and subjected to photolithography and wet-etching using hydrofluoric acid for patterning to form a mask 76 having a width of 100 µm and a length of 800 µm. Thereafter, as shown in Fig. 6B, the DH structure 74 and the underlying substrate were etched to a specified thickness by using mask 76, thereby forming an exposed surface 75 of the InP substrate 72.

Subsequently, an AlGaInAs MQW structure 78 and an InP layer 79 were consecutively formed by a selective growth technique on the exposed surface of the InP substrate 72, as shown in Fig. 6C. In the selective growth process, CBr₄ was supplied only during deposition of an Al-based compound semiconductor layer, or AlGaInAs layer in this example, at a flow rate of 0.32 µmol/minute. The flow rate of CBr₄ depends on the mask size. During the selective growth of AlGaInAs layer, deposition of the polycrystalline substance was suppressed, thereby achieving a high selective ratio.

It was then examined in the present experiments whether or not the selective growth process using CBr₄ caused adverse affects against the crystalline structure or optical characteristics of the resultant layer. The results were such that the crystalline structure of the AlGaInAs layer, i.e., compound semiconductor layer including Al, was not adversely affected by the selective growth process with respect to the surface morphology and the mirror surface thereof, and thus an excellent crystalline structure was obtained.

With respect to the optical characteristics, the AlGaInAs-based MQW structure formed by the selective growth using CBr₄ had photoluminescence characteristics and laser characteristics similar to those in the AlGaInAs-based MQW structure formed by the selective growth without using CBr₄.

From the results of the third and fourth experiments as described above, it is confirmed that CBr₄ gas supplied into the growth chamber together with the source gas suppresses the deposition of polycrystalline substance to improve the selectivity in the selective growth process without involving degradation of the crystalline quality of the resultant layer.

It is preferable to experimentally determine the flow rate of bromine-based etching gas, which depends on a variety of conditions including the composition of the compound semiconductor layer including Al, especially the Al content thereof, deposition conditions such as deposition temperature and deposition rate, and the size or surface state of the mask

The compound semiconductor layer including Al and formed by the selective growth process using the etching gas including bromine atoms is not limited to have any specific composition, and the examples of the compound semiconductor layer include AlGaInP layer, AlGaAs layer, AlInAs layer, and AlGaInAs layer. The composition of the etching gas including bromine atoms is not limited to any specific composition, and the etching gas may include CBr₄.

The growth process using the etching gas including bromine atoms may be a burying growth process, selective area growth process or butt joint growth process.

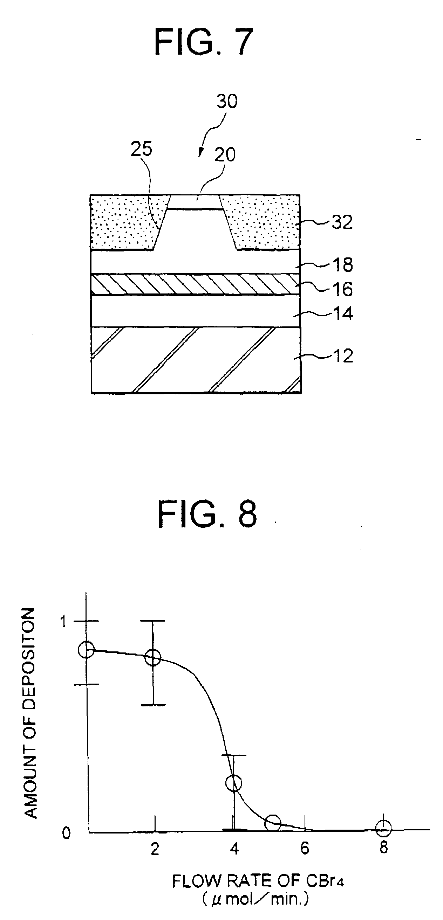

Referring to Fig. 7, a semiconductor laser device, generally designated by numeral 30, formed as an example of the semiconductor optical device according to the present invention has a structure similar to that of the conventional semiconductor laser device 10 shown in Fig. 1 except for the structure of the current blocking layer 32.

More specifically, the semiconductor laser device 30 includes an n-GaAs substrate 12, and a layered structure formed thereon and including a 1500-nm-thick n-AlGaInP ((Al_{z}Ga_{1-z})ₓIn₁₋ₓP, x=0.5 and Z=0.7) lower cladding layer 14, GaInP/AlGaInP MQW layers 16, a 1500-nm-thick p-AlGaInP ((Al_{z}Ga_{1-z})ₓIn₁₋ₓP, x=0.5 and Z=0.7) upper cladding layer 18, and a 300-nm-thick p-GaAs contact layer 20.

Among the layered structure, the contact layer 20 and the top portion of the upper cladding layer 18 are configured as a ridge stripe, both sides of which are buried by a C-doped n-AlInP layer 32 acting as a current blocking layer. The C-doped AlInP layer 32 has a carrier density of 1×10¹⁸ cm⁻³. The p-type current injection area is isolated from the current blocking layer 32 by a p-n junction, whereby a current contraction structure is achieved. A p-side electrode and an n-side electrode are formed on the contact layer 20 and the bottom surface of the GaAs substrate 12, respectively, although these electrodes are not specifically shown in the figure.

### First Embodiment for Fabrication

The semiconductor laser device of Fig. 7 can be fabricated as follows according to the first embodiment. The steps up to the step of forming the ridge stripe 25 are similar to those described with reference to Figs. 2A to 2B. The ridge stripe 25 is buried by a C-doped n-AlInP current blocking layer 32 grown in a selective growth step using a SiN selective growth mask, such as the SiN stripe mask 24 shown in Figs. 2A.

The process conditions in the selective growth used for forming a practical example of the AlInP current blocking layer 32 were as follows:
Growth temperature - 600°C;
Flow Rate of Halogen compound gas CBr₄- 5 µmol/min.;
Flow Rate of Source gas for group-III TMAl and TMIn (total) - 20 µmol/min.; and
Growth rate - 3 µm/hour.
The flow rate of CBr₄ was determined based on the composition which satisfies the matching condition with respect to the GaAs substrate, taken in further consideration of etching effect of the resultant layer.

The carrier density of the resultant C-doped AlInP layer 32 was 2×10¹⁷ cm⁻³, which was somewhat lower compared to a desired current blocking layer. Thus, the carrier density was modified to assume 1×10¹⁸ cm⁻³ by adding SiH₄ gas to additionally dope the AlInP layer with Si.

The resultant AlInP current blocking layer 32 achieved a carrier mobility which was comparable to the carrier mobility of an ordinary Si-doped AlInP current blocking layer. That is, electric characteristics were not degraded by the doping with carbon.

In the resultant structure, the 10-µm-wide mask was substantially free from the deposition of polycrystalline substance thereon after the selective growth of AlInP. Thus, it was confirmed that the addition of CBr₄ gas was effective for suppressing the deposition of polycrystalline substance.

A variety of experiments were conducted with respect to the addition of CBr₄. Referring to Fig. 8, the amount of polycrystalline substance deposited on the selective growth mask is plotted in an arbitrary unit against the flow rate of CBr₄ which ranged zero to 8 µmol/min. Fig. 8 was obtained by changing the flow rate of CBr₄ while maintaining the other conditions as listed before.

The amount of deposited polycrystalline substance generally depends on the growth conditions such as the growth temperature, the flow rate of source gas for group-III element and the A1 content, and the configuration of the mask such as the size thereof. In Fig. 8, a threshold for the amount of deposited polycrystalline substance resides at a CBr₄ flow rate of 5 µmol/min, above which the deposition of polycrystalline substance was substantially completely suppressed.

In the above experiments, if the ratio between the flow rates of the source gas for group-III element and CBr₄ gas is below 2, the deposition rate of AlInP is substantially zero due to the higher etching rate compared to the deposition rate thereof. On the other hand, if the ratio between the flow rates is above 4, a sufficient suppression effect is not obtained for the deposition of polycrystalline substance.

Thus, a preferable range of the ratio resides between 2 and 4 at a growth temperature of 600°C. If CBr₄ is replaced by CCl₄, the lower and upper limits of the range extend below 2 and above 4, respectively, due to a higher etching function of CCl₄ compared to CBr₄.

If AlGaInP, which better lattice-matches with a GaAs substrate, is selectively grown instead of AlInP, the lower limit extends somewhat lower, whereas the upper limit of the range extends significantly higher, due to a lower Al content in the source gas for group-III elements.

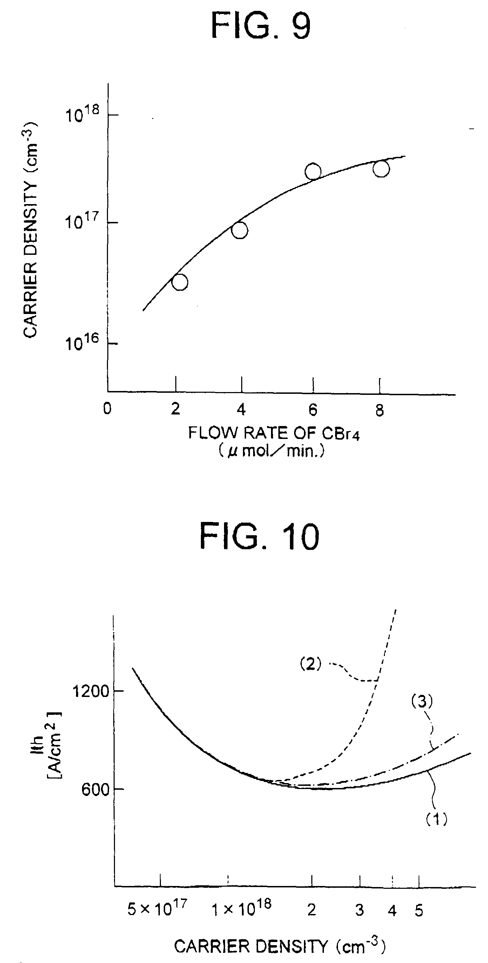

Referring to Fig. 9, the carrier density in the AlInP layer, which is selectively grown while being subjected to doping with carbon, is plotted against the flow rate of CBr₄. The carrier density in the C-doped AlInP layer increases with the increase of the flow rate of CBr₄, and has a tendency of saturation in a higher flow rate range of CBr₄. The higher flow rate range may also degrade the characteristics of the semiconductor optical device. Accordingly, it may be preferable that another n-type dopant, such as Se, be additionally used for achieving a desired carrier density.

For suppression of the deposition of polycrystalline substance on the selective growth mask, it may be correctly considered to lower the growth rate of AlInP layer itself. However, the lower growth rate of AlInP layer lowers the throughput of the semiconductor optical device and should not be used, especially in the case of selective growth of the current blocking layer which has a thickness of 1 µm or higher.

The selective growth of the AlInP layer according to the present embodiment assures a relatively higher growth rate of 3 µm/hour and scarcely suffers from a lower throughput of the growth.

The growth temperature as low as around 600°C suppresses the diffusion of Zn in the upper cladding layer. A lower growth temperature is generally disadvantageous in view of the higher deposition rate of polycrystalline substance. However, the addition of CBr₄ based on the present embodiment cancels the disadvantage.

The suppression of Zn diffusion as described above allows the Zn concentration of the upper cladding layer during the initial epitaxial growth thereof to be higher, whereby the threshold current of the semiconductor laser device can be maintained at a lower value and the temperature characteristics can be improved.

Referring to Fig. 10, the threshold current of the semiconductor laser device is plotted against the carrier density of the upper cladding layer, with the growth temperature of the AlInP layer as a parameter.

Solid line (1) is taken before the burying epitaxial growth and after the initial growth of the layered structure, whereas dotted line (2) and chain line (3) are taken after the burying epitaxial growth. Dotted line (2) indicates the relationship at a growth temperature of 700°C in a conventional technique without addition of CBr₄, and chain line (3) indicates the relationship at a growth temperature of 600°C in the embodiment.

Dotted line (2) indicates that the threshold current in the conventional technique abruptly increases above a carrier density of approximately 1.5×10¹⁸ cm⁻³ due to the diffusion of Zn caused by the heat generated during the burying growth. On the other hand, chain line (3) indicates that the threshold current in the embodiment using CBr₄ gas stays at a lower level comparable to the level of solid line (1) up to a carrier density of 3×10¹⁸ cm⁻³ due to a lower growth temperature of 600°C.

### Second Embodiment for Fabrication

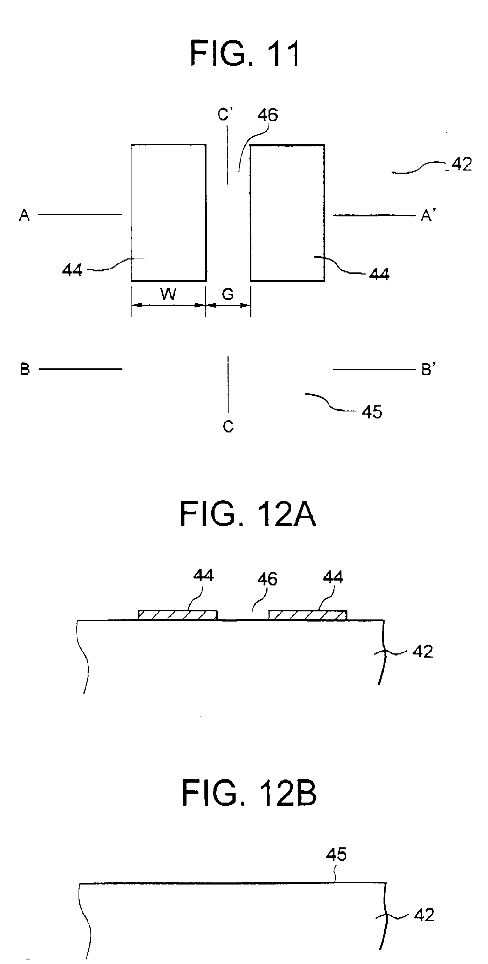

A semiconductor laser device including an AlGaInAs current blocking layer was fabricated according to the second embodiment of the present invention. Fig. 11 shows a top plan view of a pair of selective area growth masks used therein, Figs. 12A and 12B are taken along lines A-A' and B-B', respectively, in Fig. 11.

As shown in Figs. 11, 12A and 12B, a pair of SiN masks 44 were formed on an n-InP substrate 42, wherein each of the masks 44 had a width (W) of 50 µm and the gap (G) between the masks 44 was 10 µm. The surface area 46 of the substrate 42 between the masks 42 is exposed and called a mask gap area. The area 45 of the substrate 42 is a normal growth area, which is not substantially affected by the presence of the masks 42 due to a sufficient distance from the masks 42.

Subsequently, a 50-nm-thick n-InP lower cladding layer 48, a 100-nm-thick AlGaInAs layer ( λ g=1000nm) light confinement layer 50, MQW layers 52, a 100-nm-thick AlGaInAs layer ( λ g=1000nm) light confinement layer 54 and a 300-nm-thick p-InP layer 56 were consecutively grown on the disposed surface of the substrate 42 by a MOCVD technique using the SiN masks 44 as a selective area growth masks.

The n-InP lower cladding layer 48 was doped with Se to have a carrier density of 1 ×10¹⁸ cm⁻³. The MQW layers 52 were such that each-of the well layers had a thickness of 5 nm and a strain of +1.0%, each of the barrier layers had a thickness of 10 nm and a composition corresponding to λ g=1000 nm, and the number of well layers is six. The p-InP layer 56 was doped with Zn to have a carrier density of 1×10¹⁸ cm⁻³.

The process conditions for the growth were such that the growth temperature was 650°C, the growth rate at the normal growth area 45 was set at 1.2 µm/hour, and CBr₄ gas was introduced at a flow rate of 2 µmol/min. during growth of the AlGaInAs layer in addition to the source gas for AlGaInAs.

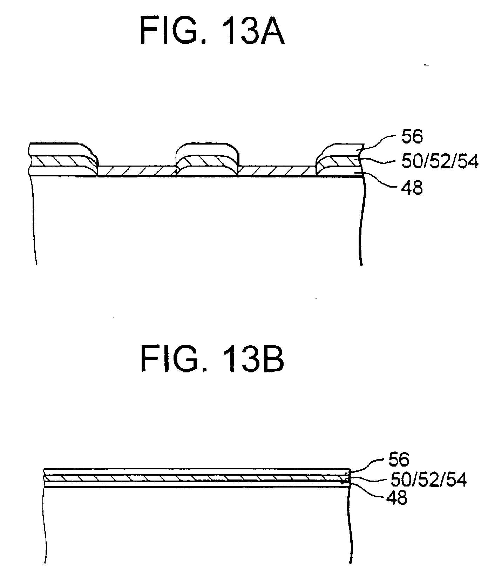

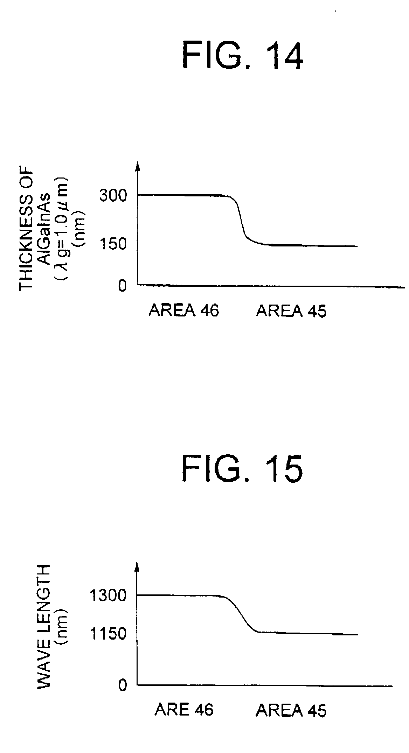

Figs. 13A and 13B show after the selective growth and were taken along lines A-A' and B-B', respectively, in Fig. 11. After the selective area growth, the film thickness of the mask gap area 46 is higher by about twice than the film thickness of the normal growth area 45, as shown by the profile shown in Fig. 14.

As a result of the difference in the deposition thickness, the lasing wavelength of the MQW layers is longer in the mask gap area 46 than in the normal growth area 45. This is shown in Fig. 15, wherein the lasing wavelengths are 1300 nm and 1150 nm, respectively, in the mask gap area 46 and the normal growth area 45.

By taking advantage of the principle of the above embodiment, a new structure of a semiconductor optical device can be formed wherein the mask gap area 46 is formed as a laser element and the normal growth area 45 is formed as a waveguide area for passing the laser emitted by the laser element substantially without absorbing the laser. Both the laser element area and the waveguide area can be formed by a common growth process.

In the above embodiment, the flow rate of the CBr₄ introduced during deposition of AlGaInAs layer which was as low as 2 µmol/min. scarcely affected the electric characteristics of the AlGaInAs layer due to a smaller carbon dosage of the AlGaInAs. The addition of CBr₄ gas suppressed the deposition of polycrystalline substance on the masks as encountered in the conventional process.

The lower flow rate of CBr₄ allows the AlGaInAs layer, i.e., compound semiconductor layer including Al, to have either the n-conductivity or the p-conductivity depending on doping the layer with Se or Zn. Thus, electric characteristics of the layer can be controlled as desired.

A modulation doping process for the barrier layers was also conducted for trial by increasing the flow rate of CBr₄ during growth of the barrier layers up to 20 µmol/min., which resulted in a carrier density of 1×10¹⁸ cm⁻³ in the barrier layer due to the increased carbon doping. This modulation doping function may be practically used for modulation of the barrier layers in a MQW structure.

### Third Embodiment for Fabrication

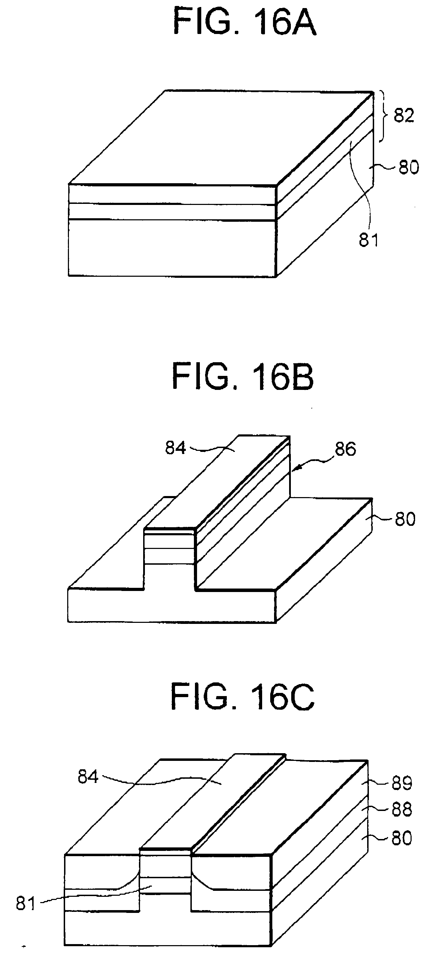

Referring to Figs. 16A to 16D, the principle of the present embodiment is applied to a semiconductor laser device having a ridge stripe (or mesa structure).

In Fig. 16A, an AlGaInP-based double heterojunction structure 82 including GaInP/AlGaInP MQW layers 81 is formed on an n-GaAs substrate 80. Subsequently, as shown in Fig. 16B, a stripe mask 84 is formed on the DH structure 82, followed by selective etching of the DH structure 82 by using the stripe mask 84 to configure a ridge stripe 86.

Thereafter, as shown in Fig. 16C, a p-AlInP layer 88 and an n-AlInP layer 89 are consecutively grown based on the principle of the present embodiment as current blocking layers for burying the ridge stripe 82 by the current blocking layers 88 and 89 at both sides thereof using the stripe mask 84 as a selective growth mask. After growing a p-AlGaInP cladding layer and p-GaAs contact layer on the entire area, a p-side electrode and an n-side electrode are then formed on the top and bottom, respectively, of the wafer, thereby achieving a semiconductor laser device.

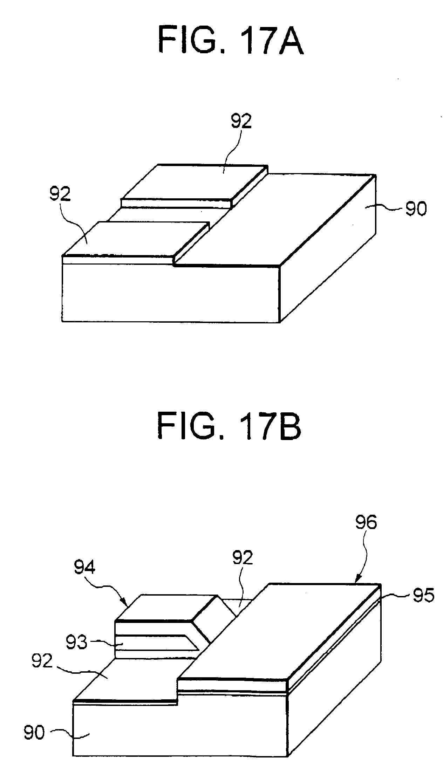

Referring to Figs. 17A and 17B, a selective area growth technique will be described, wherein a pair of selective growth masks 92 are used for fabricating different types of optical elements on a single semiconductor substrate 90. The pair of selective growth masks 92 are formed on a first area of the substrate 90 with a small space therebetween, whereas a second area has no such mask, as shown in Fig. 17A. By using the selective area growth masks 92, DH structures 94 and 96 are grown in the first and second areas, respectively, of the substrate 90 based on the principle of the present embodiment. The principle of the present embodiment is used in growth of a compound semiconductor layer including Al, e.g., an AlGaInP layer. The DH structure 94 in the first area is of a ridge stripe and has a larger height, whereas the DH structure 96 has a uniform height.

In the second embodiment of fabrication for the AlGaInAs layer, light confinement layers are grown based on the principle of the present embodiment.

### Fourth Embodiment for Fabrication

A butt joint growth as mentioned before was used in the fourth experiments, and is preferably applied to fabricating an integrated optical device including a semiconductor laser device and an optical modulator.

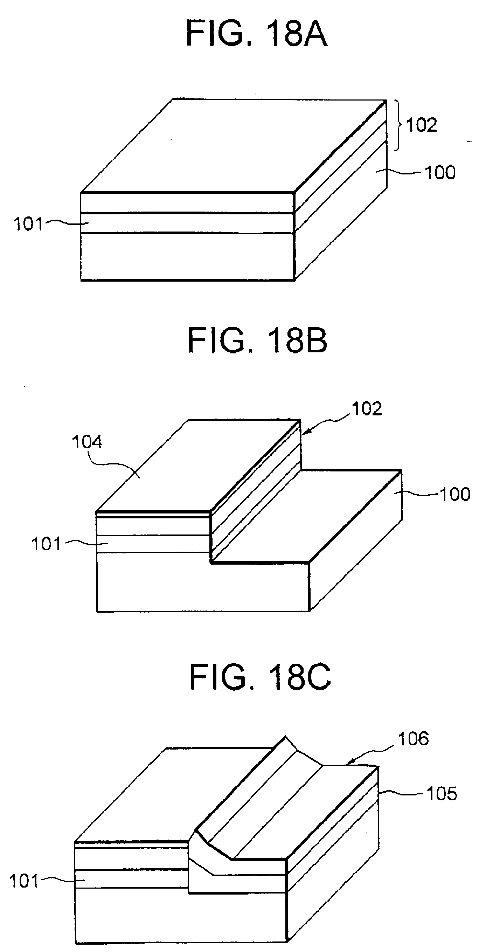

Figs. 18A to 18B show consecutive steps of the butt joint growth process, wherein MQW slayers 101 and MQW layers 105 are grown by the butt joint growth process in the first and second areas, respectively.

In Fig. 18A, after forming a diffraction grating, a DH structure 102 including MQW layers 101 is grown on the entire area of an InP substrate 100, to form a layered structure of a distributed feedback laser device (DFB-LD). Subsequently, as shown in Fig. 18B, a SiN mask 104 is formed on the top of the first area, followed by etching of the DH structure 102 exposed from the SiN mask 104 as well as the top portion of the InP substrate 100 in the second area. The portion of the DH structure 102 left in the first area is formed as a laser device.

Subsequently, as shown in Fig. 18C, a DH structure 106 of an optical modulator including MQW layers 105 having a lasing wavelength of 1500 nm is grown on the exposed surface of the InP substrate 100 by using the selective growth technique based on the present embodiment.

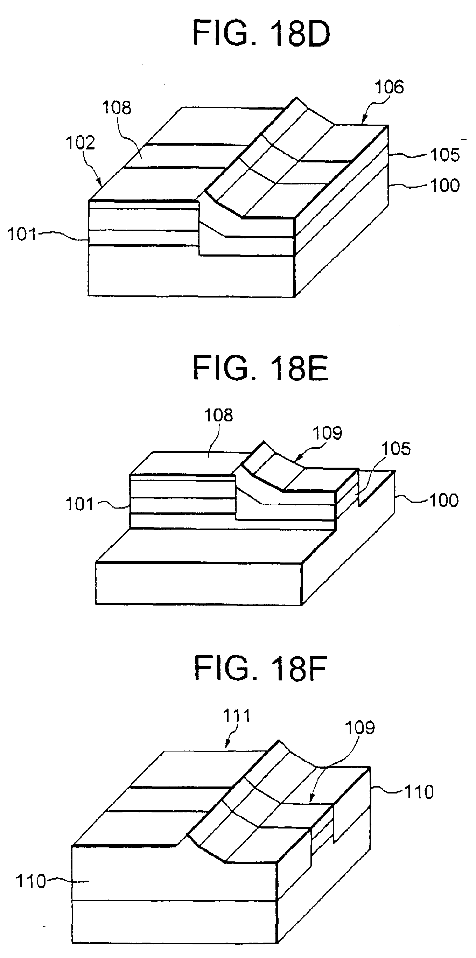

Thereafter, the SiN mask 104 is removed, and another stripe mask 108 is formed on the top surface in the first and second areas, as shown in Fig. 18D. Then, as shown in Fig. 18E, DH structures 102 and 106 are etched together with the top portion of the InP substrate 100 by using the SiN mask 108 as an etching mask, to form a mesa stripe extending in the first and second areas and expose the InP substrate 100 at both sides thereof. Subsequently, as shown in Fig. 18F, a Fe-doped InP current blocking layer 110 is grown by a selective growth technique using the SiN mask 108 as a selective growth mask to bury the mesa stripe at both sides thereof. Thereafter, n-side and p-side electrodes are formed in each of the first and second areas to achieve a laser device and an optical modulator in the first and second areas, respectively, whereby an integrated semiconductor optical device can be obtained.

Since the above embodiments are described only for examples, the present invention is not limited to the above embodiments and various modifications or alterations can be easily made therefrom by those skilled in the art without departing from the scope of the present invention.

## Claims

1. A semiconductor optical device comprising a semiconductor substrate (12), and a layered structure formed thereon, said layered structure including a first conductivity-type current injection layer (18, 20) formed as a ridge stripe (25) and a second conductivity-type current blocking layer (32) burying said current injection layer (18, 20) at both side of said ridge stripe (25), characterized in that said current blocking layer (32) is doped with impurities including at least carbon.

2. The semiconductor optical device as defined in claim 1, wherein said semiconductor substrate is a GaAs substrate (12), and said current blocking layer (32) is either an AIGaInP layer or an AlGaAs layer.

3. The semiconductor optical device as defined in claim 1, wherein said semiconductor substrate (12) is an InP substrate, and said current blocking layer is an AlGaInAs layer.

4. The semiconductor optical device as defined in claim 1, wherein said impurities additionally include Si and/or Se.

5. A method comprising the steps of forming a compound semiconductor layer overlying a substrate and including Al, and forming a semiconductor optical device including said compound semiconductor layer, characterized in that said compound semiconductor layer forming step uses a mixture of source gas for said compound semiconductor layer and halogen compound gas including halogen and carbon.

6. The method as defined in claim 5, wherein said semiconductor substrate (12) is a GaAs substrate, and said current blocking layer is either an AIGaInP layer or an AlGaAs layer.

7. The method as defined in claim 5, wherein said semiconductor substrate is an InP substrate, and said current blocking layer is AlGaInAs layer.

8. The method as defined in claim 5, wherein said epitaxially growing step additionally dopes said current blocking layer with at least one of Si, Se and Zn.

9. The method as defined in claim 5, wherein said halogen compound gas includes CCl₄ and/or CBr₄.

10. The method as defined in claim 5, wherein said compound semiconductor layer is one of AlGaInP layer, AlGaAs layer, AlInAs laye, and AlGaInAs layer.

11. The method as defined in claim 5, wherein said compound semiconductor layer forming step is used as a burying growth step, a selective area growth step or a butt joint growth step.
